# EUROPEAN PATENT SPECIFICATION

(11) **EP 1 540 727 B1**
(45) Date of publication and mention of the grant of the patent: **20.10.2010**
(21) Application number: 03795528.3
(22) Date of filing: 10.09.2003
(51) Int. Cl.: H01L 23/10, H01L 21/50

(54) **METHOD FOR SEALING A MICROCAVITY AND PACKAGE COMPRISING AT LEAST ONE MICROCAVITY**
VERFAHREN ZUM VERSCHLIESSEN EINER MIKROKAVITÄT UND GEHÄUSE MIT MINDESTENS EINER MIKROKAVITÄT
PROCEDE DE FERMETURE D'UNE MICROCAVITE ET BOITIER COMPRENANT AU MOINS UNE MICROCAVITE

(30) Priority: 10.09.2002 SE 0202681
(43) Date of publication of application: 15.06.2005
(73) Proprietor: Niklaus Consulting, 183 61 Täby (SE); BonSens AB, 114 21 Stockholm (SE); Oberhammer, Joachim, 113 26 Stockholm (SE)
(72) Inventor: Niklaus, Frank, 112 26 Stockholm (SE); Stemme, Göran, 104 05 Stockholm (SE); Oberhammer, Joachim, 113 26 Stockholm (SE)
(74) Representative: Geary, Stephen
(86) International application number: PCT/SE2003/001408
(87) International publication number: WO 2004/025727

(56) References cited:
- EP-A2- 0 962 275
- US-A1- 2002 054 422
- US-B1- 6 499 354
- 2002, KTH, STOCKHOLM article NIKLAUS F.: 'Adhesive wafer bonding for microelectronic and microelectromechanical systems', page 49, XP002974343

## Description

### Technical Field

The present invention relates to a method for hermetically sealing a microcavity as defined in claim 1.

It also relates to a hermetically sealed package comprising a microcavity as defined in claim 13.

### Background

Micro Electro-Mechanical Systems (MEMS) devices range in size from some µm to a few mm and include pressure sensors, impact detectors and focal plane arrays, for example, for infrared cameras. Such systems must often be provided with hermetic packages, to protect their structures from harsh external environments and/or to ensure special atmospheric conditions, such as a high-vacuum, inside the package, to ensure the functionality of the device. The packages also protect the structures from mechanical impacts.

The package may be sealed on wafer-level or on chip-level. In the latter case, the wafer is completely diced into chips before the sealing. The general advantage of wafer-scale packaging is that a large number of packages, for example, focal plane arrays, can be encapsulated and protected at substantially the same time, which will significantly decrease the cost per unit. The testing of the encapsulated device can then be done on wafer-level before the wafers are diced, which would not be possible if the wafers were not protected by encapsulation.

Wafer-level bonding techniques are widely used for this purpose. Conventional wafer-level bonding techniques include fusion bonding, compression bonding, anodic bonding and eutectic bonding. Such methods require high temperatures, high pressures, high voltages and/or special surface conditions. These requirements are in-compatible with many MEMS devices and with standard microelectronic manufac-turing processes. Therefore, the hermetic sealing of MEMS devices and/or micro-electronic circuits is difficult and costly.

Great effort has been made to develop bonding methods compatible to standard microelectronic processes. Recent techniques include, for example:
- localized heating bonding, which requires complicated structures and manufac-turing steps.
- solder bonding, which affects the atmosphere inside the microactivity,
- eutectic bonding, which, if used in larger areas often suffers from a low bond yield due to residue oxides and dirt at the metal surfaces,
- low-temperature adhesive bonding, which does not achieve hermetically sealed microactivities

Some wafer bonding techniques, for example, solder bonding and eutectic bonding, are described in Niklaus: "Adhesive Wafer Bonding for Microelectronic and Microelectromechanical systems, Royal Institute of Technology, Stockholm published on 23 September 2002, TRITA-ILA 0204, ISSN 0281-2878, after the priority date of this patent application.

Thus, the method for manufacturing and sealing sensors, actuators, integrated circuits, and integrated sensor systems is critical for the long-term stability of the devices.

Other techniques include those described in the following documents EP-A-606 725, U.S. Reissue Patent Re 35,119; US-A-6413800; US -A-5641713; US-A-5053358; and US Patent Application 2002/0017713.

### Summary of the Invention

It is therefore and object of the present invention to provide a method for creating a hermetic microactivity by wafer- or chip-level bonding, which is compatible with MEMS devices and standard micro-electronics circuits.

This object is achieved according to the invention by a method of hermetically sealing a microactivity comprising a first wafer and second wafer, said method

The object is also achieved by a hermetically sealed package comprising a microcavity according to claim 13.

The method of the invention is particularly well suited for the hermetic sealing of microelectromechanical and microelectronic devices, including sensors, actuators (transducers) and integrated circuits. The method enables hermetic sealing of packages on wafer-level in situations where this is not possible with prior art methods. In this way very many packages may be sealed in substantially the same time as a single package. Hermetic sealing can be achieved even with low-temperature bonding, which does not harm components. Thereby, further processing and testing of the packages can also be done on wafer-level, which greatly reduces the manufacturing costs.

Hermetic sealing is often used to achieve high-vacuum packages or sealed packages comprising a controlled atmosphere, but may also be used for protection of components that do not require a particular atmosphere. In a preferred embodiment the first wafer is a germanium wafer. A germanium window is suitable if the package is to be used as a focal plane array in an infrared camera, since germanium is transparent in the infrared spectrum. Of course, other materials that are transparent in the infrared spectrum could be used as well.

In most cases, one or both wafers comprise components that are to be enclosed in the hermetically sealed microcavity. Such components may be, for example, resonance sensors, pressure sensors, acceleration sensors, thermal radiation sensors, (e.g. infrared bolometer arrays), or other radiation sensor, switches, such as RF switches, surface acoustic wave (SAW) filters, lasers, laser modulators, VCE lasers, actuators or RF-MEMS devices. Integrated circuits (ICs) can be implemented beside or underneath the sensors. Electrical interconnects from the ICs or the sensors to contact pads (bond-pads) can also be present on the wafer. In this case the electrical interconnects would typically be covered with an electrically non-conductive material such as silicon nitride or silicon oxi-nitride in order to avoid short-circuits in later process steps.

The components may also be, for example, implantable devices that should be sealed for protection but which do not have to be in a vacuum.

One wafer can also be an unprocessed (flat) wafer (e.g. glass or silicon).

With the method according to the invention, components on the wafers can be manufactured by any cost-efficient standard process, such as methods commonly employed in the production of Application-Specific Integrated Circuits (ASICs), in IC foundries and/or in MEMS foundries. The method according to the invention enables sealing of components on wafer-level, that is, before the wafer is diced to form chips.

The adhesive bonding provides the bond strength while the diffusion barrier ensures the hermetic sealing of the microcavity. Several diffusion barriers may be used on the inside and/or outside of the adhesive bonding.

It will be recognized by the skilled person that the diffusion barrier in most cases also have a bonding effect, which is usually not strong enough to be the sole bonding structure for the package. The terms bonding material or bonding structure in this document therefore denotes the main bonding material or structure. The term diffusion barrier should not be taken to imply that this barrier cannot have a bonding effect also.

The wafer may comprise of any material used in the art for such purposes, for example, glass or silicon.

The diffusion barrier is typically formed by one or more non-organic materials, such as metals, nitride, silicon, etc. Suitable metals are aluminium, gold, nickel and others. However, organic materials that work as diffusion barriers for the relevant gases, moistures or fluids can also be used.

The materials for the diffusion barrier can be deposited and patterned by suitable means. Typical deposition techniques include sputtering, CVD deposition, plating, electroplating, spin coating, screen printing. The patterning can be done with lithographical techniques and wet etching, dry etching, electroplating, etc. The skilled person is familiar with such techniques.

Suitable materials for use as intermediate bonding materials are typically organic materials like polymers (benzocyclobutene (BCB), epoxies, thermoplastics, thermosetting, elastomers etc.) Suitable non-organic materials can also be used, for example spin-on glass. The deposition of these materials is typically done by spin coating, plating, contact printing, screen printing, evaporation, or similar techniques. The patterning of the intermediate bonding materials can be done by photolitographical techniques, in particular if a photosensitive material is used as the intermediate bonding material. It can also be done by dry or wet etching, or similar techniques.

In a preferred embodiment, sealing material for the diffusion barrier is provided on both wafers, in such a way that the sealing material on both wafers will interact to form one diffusion barrier. This ensures that a hermetic sealing can be achieved. If two different materials are used, a eutectic bond can be formed in the diffusion barrier.

Advantageously, the sealing material provided on one or both wafers is shaped in such a way that it is plastically deformed by pressure when the two wafers are joined. This may be used to compensate for non-uniformity of the opposed substrate surface in order to achieve a complete closure of the gap to achieve a hermetic seal. The materials can be fused together when they are deformed, by cold (or warm) welding.

One or more electrically conductive components may be provided, which extend between the diffusion barrier and the wafer, and between the bonding material and the wafer, to form electrical feed-through lines that provide electrical contact between the inside and the outside of the sealed microcavity.

Electrically conductive components may also be provided on the first and/or second wafer, to achieve defined electrical contact lines between the first and the second wafer in the bonding and sealing procedure.

A notch may be provided in one or both wafers, for example by etching. This will increase the height of the microcavity and make room for larger components, such as MEMS devices. Alternatively, the height of the microcavity can be increased by the use of spacers. Suitable spacers are various metals, such as gold, which can be plated or electroplated on the wafer or formed using masking and etching techniques. The spacers may also be applied by sputtering, evaporation or chemical vapour deposition.

A getter material may be provided in the microcavity before bonding. This will improve the stability of the vacuum over time. Some getter materials require activation, in which case electrical feed-through lines connecting the getter to the outside are required. The skilled person is well acquainted with the use of getters in this context.

In this document, the terms "wafer" and "substrate" are used interchangeably, the difference between them merely amounting to dimensions thereof. "Component" means any structure that is provided as a sub-unit on a wafer or substrate, and can comprise entire devices as well as parts of such devices, even a single piece of material. "Adhesive material" indicates any material or material combination that can be used as an intermediate bonding material when bonding two wafers.
"Diffusion barrier" means a structure of any material or material combination that can be used as a (diffusion) barrier against the desired materials (e.g. gases, fluids, etc.)

### Brief Description of the Drawings

In the following the invention will be described in more detail, by way of embodiments intended to serve as examples only, and with reference to the appended drawings, in which:
Figures 1A-11D, Figures 14, 15, 16A-22C are cross sections of a hermetically sealed microcavity according to the invention, and
Figures 1A and 1B illustrate a simplified manufacturing process according to a basic embodiment of the invention
Figures 2A and 2B illustrate a simplified manufacturing process according to a further embodiment of the invention
Figures 3A and 3B illustrate a simplified manufacturing process according to a first basic embodiment of the invention where one wafer comprises a notch.
Figures 4A and 4B illustrate a simplified manufacturing process according to an embodiment where the diffusion barrier is formed by three interacting parts.
Figures 5A, 5B, 6A and 6B illustrate embodiments where the diffusion barrier is designed to be deformed when the wafers are joined.
Figures 7A and 7B illustrate an embodiment in which diffusion barriers are provided on both sides of the bonding material.
Figures 8A and 8B illustrate an embodiment where bonding material and diffusion barrier are provided on both wafers and aligned before the wafers are joined.
Figures 9A, 9B, 9C and 9D illustrate ways of achieving electrical connections within the microcavity and from the microcavity to the outside.
Figures 10A, 10B, 10C and 10D illustrate a simplified manufacturing process according to a second basic embodiment of the invention
Figures 11A, 11B and 11C illustrate the use of a spacer.
Figure 12 shows a cross-section of the microcavity and surroundings according to one embodiment, seen from above.
Figure 13 shows a cross-section of the microcavity and surroundings according to an alternative embodiment, seen from above.
Figures 14 and 15 show alternative embodiments in which the diffusion barrier diffusion barrier is formed by several interacting parts.
Figures 16A-16D show alternative results of further processing of the package shown in Figure 10C.
Figures 17A-17C show sealing of the microcavity according to another embodiment.
Figures 18A-18C illustrate a method for forming vertical contacts from the microcavity.
Figures 19A-19C and 20A-20C show alternative ways of forming the bond.
Figures 21A and 21B illustrate, in cross-section, examples of complete packages including components.
Figures 22A-22C show a larger section of the wafers, comprising several sealed packages according to the invention.

### Detailed Description of Embodiments

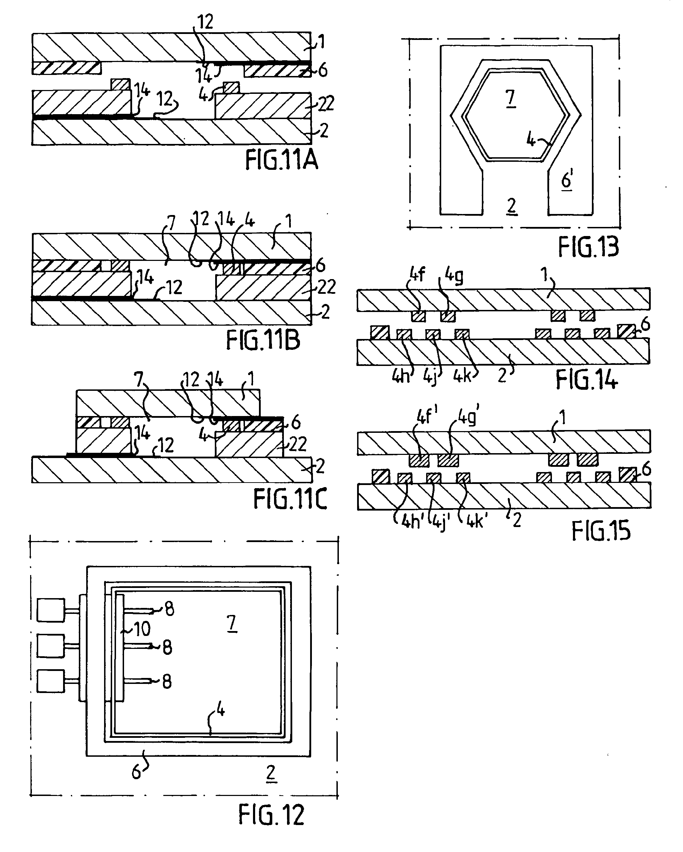

It should be noted that the term "ring" throughout the document indicates any closed shape, not necessarily a circle. As shown in Figures 12 and 13, the bonding material and the sealing material can be applied in any suitable shape, for example a square or a hexagon. In the embodiment where the diffusion barrier is applied on the outside of the package, it may be shaped as a cap. As shown in Figure 13, the bonding structure does not have to be a closed shape.

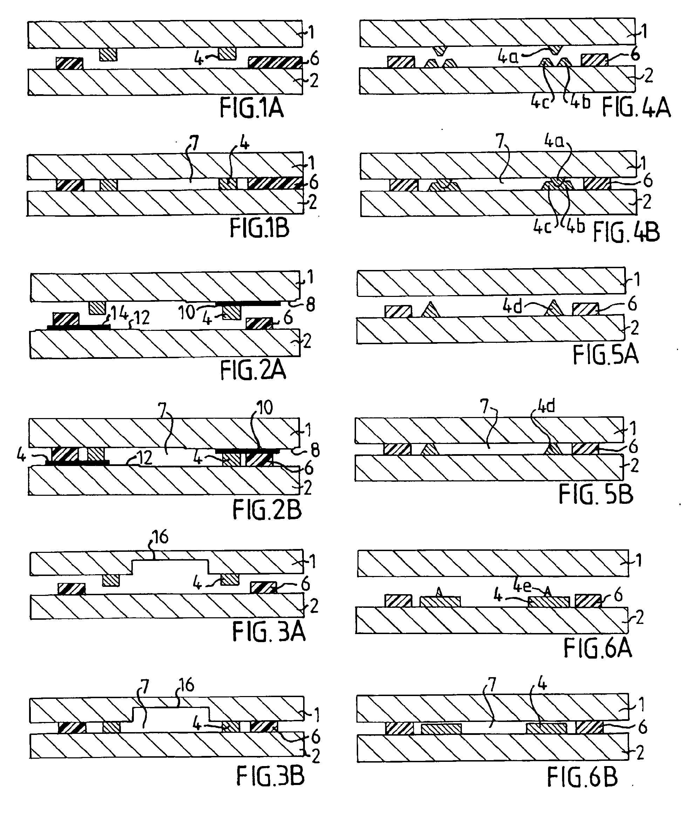

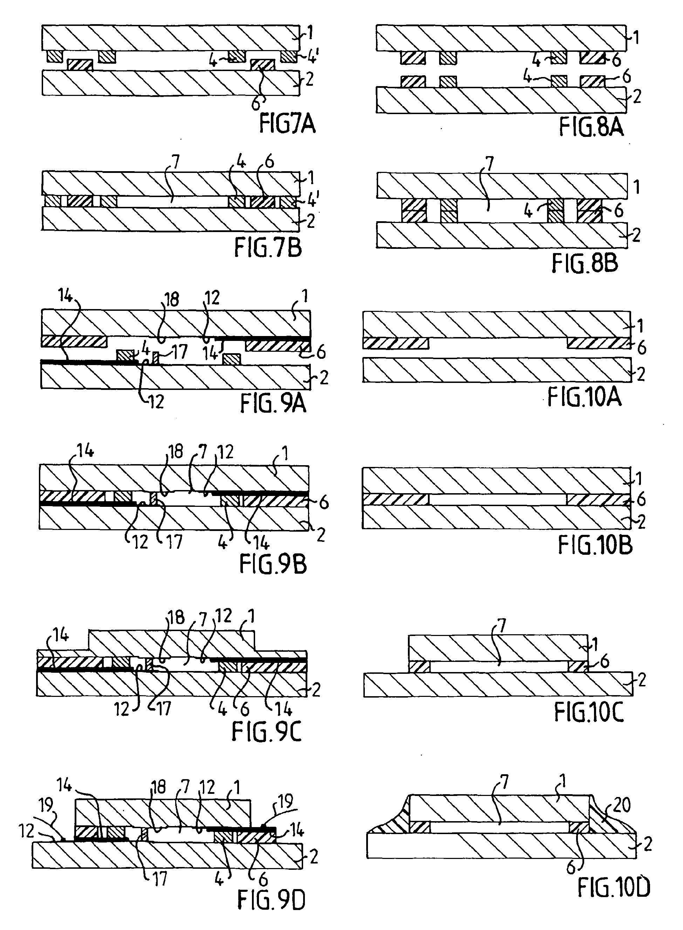

The general bonding and sealing process according to a first embodiment of the invention will now be discussed with reference to Figures 1A and 1B. This process, with the necessary adjustments, is used in the embodiments shown in all other Figures except Figures 10A-10D, 16A-16D, 17A-17C, 19A-19C and 20A-20C. In Figure 1A a first wafer 1 and a second wafer 2 are shown in cross-section. Normally, one or both wafers 1, 2 comprise one or more components (not shown). The processes used for manufacturing the components on the first and the second wafer, respectively, do not have to be compatible with each other.

Before, in between or after the fabrication of the components on the wafers (this depends on a suitable and efficient processing flow for the components) the bonding material and the diffusion barrier are deposited on one or both wafers around the components that have to be hermetically sealed. In Figure 1A, a ring, or other closed shape, of sealing material that is to form the diffusion barrier 4 has been deposited on the first wafer 1. A ring, or other closed shape of the material that is to form the intermediate bonding ring 6, larger than the diffusion barrier ring, has been deposited on the second wafer. The material for the bonding ring 6 and the diffusion barrier 4 may instead be deposited on the same wafer. Also, one or both materials may be deposited on both wafers 1, 2, as will be discussed in below.

The two wafers 1, 2 are then aligned and bonded to each other by applying pressure, to produce the package shown in Figure 1B. The bonding is typically achieved by applying heat to cure the intermediate bonding material and achieve a bond between the wafers. Some intermediate bonding materials also have alternative curing mechanisms, such as ultraviolet light or time-dependent curing. An example of the latter is a two-component epoxy.

The bonding process is performed in a controlled atmosphere corresponding to the desired environment inside the microcavity. If the microcavity should contain vacuum, the bonding process is performed in vacuum.

In Figure 1B, a hermetic microcavity 7 has been formed between the first and second wafer 1,2 by means of a diffusion barrier 4 inside a bonding ring 6.

Figures 2A and 2B illustrate a simplified manufacturing process according to a further embodiment of the invention. In Figure 2a, a microcavity is to be formed between a first wafer 1 and a second wafer 2. On the first wafer 1 material to form a diffusion barrier 4 has been deposited. On the second wafer material that is to form the intermediate bonding ring 6 has been deposited.

In Figure 2A a first electrically conductive wire 8 has been provided on a part of the first wafer 1, said wire 8 extending from the inside of the diffusion barrier 4 to what will be the outside of the package. Between the electrically conductive wire 8 and the diffusion barrier 4 a first electrical isolation layer 10 has been provided. The electrical isolation layer 10 extends from the inside of the diffusion barrier 4 to what will be the outside of the package, but not necessarily as far out as the electrically conductive wire 8.

After the bonding of the two wafers 1, 2, parts of the wafers can be removed by dicing, etching or other suitable means, for example, to expose electrical contacts, bond-pads, etc. The etching or dicing can also be used for completely separating the different chips. This will be discussed in connection with Figures 9C and 9D and Figures 11C and 11D.

Similarly, in Figure 2A a second electrically conductive wire 12 has been provided on a part of the second wafer 2, said wire 12 extending from the outside of the intermediate bonding ring 6 to what will be the inside of the microcavity. Between the electrically conductive wire 12 and the intermediate bonding ring 6 a second electrical isolation layer 14 has been provided. The electrical isolation layer 14 extends from the outside of the intermediate bonding ring 6 to what will be the inside of the microcavity, but not necessarily as far as the electrically conductive wire 12.

The result after bonding is shown in Figure 2B. As in Figure 1B, a hermetic microcavity 7 has been formed between the first and second wafer 1,2 by means of a diffusion barrier 4 inside a bonding ring 6. A first 8 and a second 12 electrically conductive wire extend from the inside of the microcavity 7 to the outside of the package. The wires 8, 12 are insulated from the bonding material 6 and the diffusion barrier 4 by electrical isolation layers 10, 14 in order to avoid short-circuits in subsequent process steps. The isolation layers are formed in a non-conductive material, such as silicon nitride or silicon oxi-nitride.

In Figure 3B the first wafer comprises a notch 16 in the area of the wafer inside the diffusion barrier 4. This notch may be used to provide additional space, for example, for bulk micromachined devices, and may be achieved by any suitable method, for example by etching. As before, the intermediate bonding material is provided on the second wafer 2. The resulting package is shown in Figure 3B. A microcavity 7 comprising a notch 16 is surrounded by a diffusion barrier 4 and an intermediate bond 6.

Figures 4A and 4B illustrate a simplified manufacturing process according to an embodiment where the diffusion barrier is formed by three interacting parts. In Figure 4A, a first diffusion barrier ring 4a, having a tapered profile has been deposited on the first wafer 1. As before, the bonding material has been deposited on the second wafer 2 in a larger ring than the diffusion barrier. On the second wafer has also been deposited a second 4b and a third 4c diffusion barrier ring of diffusion barrier material, having tapered profiles. The three rings 4a, 4b, 4c have been placed in such a way that, when the two wafers 1, 2 are joined together, the second ring 4b will lie adjacent the first ring 4a, on its outside, and the third ring 4c will lie adjacent the first ring 4a on its inside. In this way, the three rings 4a, 4b, 4c will interact to form a diffusion barrier around the hermetic microcavity, as shown in Figure 4B.

The three diffusion barrier rings 4a, 4b, 4c may be formed of two or three different materials. Also, several different materials may be used in the adhesive material to support the hermetic sealing capabilities, for example by applying adequate bonding conditions to achieve eutectic bonding of metal sealing rings.

In Figure 5A both the bonding ring 6 and the diffusion barrier 4d have been deposited on the second wafer 2. The diffusion barrier 4d has a tapered profile and extends higher above the second wafer 2 than the bonding ring 6. In this way, during bonding the diffusion barrier 4d will be plastically deformed, to produce the result shown in Figure 5B. As will be obvious to the skilled person, the bonding ring 6 and the diffusion barrier could be placed on different wafers, in this embodiment as well as in the previous ones.

Figures 6A and 6B illustrate an alternative embodiment where the diffusion barrier is designed to be deformed when the wafers are joined. As in Figure 5A, the bonding ring 6 and the diffusion barrier 4e have both been deposited on the second wafer. In this embodiment, the diffusion barrier comprises a first ring adjacent the second wafer and a second ring on top of the first ring, the second ring having a tapered profile and extending higher above the second wafer 2 than the bonding ring 6. As can be seen in Figure 6B, the second ring 4e has been plastically deformed during bonding. Instead of one second ring, as shown in the Figures, of course, several rings could be provided on top of the first ring.

Figures 7A and 7B illustrate an embodiment in which diffusion barriers are provided on both sides of the bonding material. In Figure 7A a first 4 and a second 4' diffusion barrier ring of material, that are to form a diffusion barrier is deposited on the first wafer in such a way that they will be placed inside the bonding ring 6 and outside the bonding ring 6, respectively, with respect to the hermetic microcavity, when the first and second wafer 1,2 are aligned, as shown in Figure 7A. Figure 7B shows the resulting microcavity with a diffusion barriers 4, 4' on both sides of the bonding ring 6.

Figures 8A and 8B illustrate an embodiment where matching rings of bonding material 6 and matching rings of diffusion barrier 4 material are provided on both wafers 1, 2 and aligned before the wafers are joined. In this embodiment, the diffusion barrier can be used to provide a eutectic bond between the wafers, in addition to the bonding material 6. To achieve this, the diffusion barrier is made up of two different materials (typically two different metals, for example, lead, Pb, and pewter, Sn) are used to create a eutectic bond at their interface. The eutectic phase will additionally promote the rim deformation, the surface-to-surface bonding and ultimately the gap closing. The eutectic bond is formed when the two materials form an alloy because of the heat and pressure applied. Bonding may also be enforced by fusing caused by plastic metal deformation.

Figures 9A, 9B, 9C and 9D illustrate how components can be placed on the two wafers in a suitable way, for example, by standard metal deposition techniques, so that a defined electrical contact between components on the two wafers can result after the bonding procedure.

In Figure 9A, electrically conductive wires 12 with insulating layers 14 are provided on the wafers 1, 2 in the same manner as in Figure 2A. The diffusion barrier 4 is placed on the second wafer 2 and the adhesive material for the bonding ring 6 is placed on the first wafer 1. In addition there is an electrically conductive component 17 extending from the wire 12 provided on the second wafer 2 in the direction towards the first wafer 1. The first wafer 1, inside the microcavity, comprises a component or a wire 18 aligned with the electrically conductive component 17.

Figure 9B shows the package after the bonding procedure has been carried out. The result is a sealed package like the one shown in Figure 2B but with an electrical connection 17 between the wire 12 on the second wafer and the component or wire 18.

Figure 9C shows the package of Figure 9B after the first wafer has been patterned by sawing or etching.

Blank etching and self-aligned etching can be used to provide the package shown in Figure 9D. Here, the second wafer 2 and the electrically conductive wires 12 extend outside the remaining part of the first wafer 1. Contacts 19 can be provided to the electrically conductive wires 12 outside of the microcavity 7.

Figures 10A, 10B, 10C, and 10D illustrate a simplified manufacturing process which does not fall under the invention, in which the diffusion barrier 4' is provided on the outside of the bonding ring 6. In this case, the adhesive material for the bonding ring 6 is first applied to one or both wafers. In Figure 10A the adhesive material is shown on the first wafer 1. In this example no diffusion barrier is applied before the bonding stage. Bonding is performed as discussed in connection with Figure 1A, to produce a hermetic microcavity 7, as shown in Figure 10B.

The wafer is then diced, to separate the chips from each other, partly or completely, and part of the first wafer 1 is removed by sawing or etching in a manner known per se. Usually, the outermost part of the adhesive material is removed as well. The result is shown in Figure 10C in which the second wafer 2 extends wider than the remaining part of the first wafer 1 and the adhesive material 6. Finally, a hermetic sealing layer 20 is provided on the outside of the first wafer and the adhesive material, covering the part of the intermediate bonding material that is exposed to the surrounding atmosphere).

The hermetic sealing layer 20 may be applied, for example, by plating, electroplating, sputtering, or CVD deposition. The material used can be selected from metals, nitride, etc. that prevent diffusion of the relevant moistures and/or gases. The hermetic sealing layer 20 can be applied in a high-vacuum atmosphere. Since the adhesive material is permeable to gasses the vacuum atmosphere during this step can be achieved inside the microcavity and will be sealed off during the application of the hermetic sealing layer 20. To facilitate the establishment of the desired atmosphere inside the microcavity, the communication between the atmosphere inside the microcavity and the atmosphere outside the microcavity can be improved by having an evacuation channel in the bonding ring, however, it is more difficult to seal such an opening in the bonding ring in a reliable way. A bonding ring with one or more narrow sections to improve the evacuation of the microcavity and still maintain a continuous wall for the deposition of the diffusion barrier, will ensure a high quality sealing.

Of course, the example shown in Figures 10A -10D can be combined with the embodiment shown in Figures 1A and 1B, in which case a diffusion barrier 4 may be provided inside of the adhesive material 6 before the bonding.

Figures 11A, 11B and 11C illustrate one embodiment for increasing the height of the microcavity. On one of the wafers , in this case the second wafer 2, a spacer 22 is provided between the second wafer 2 and the diffusion barrier 4. In addition electrically conductive wires 12 with isolation layers 14 are provided between the first wafer 1 and the adhesive material 6 and between the second wafer 2 and the spacer 22, in the manner discussed in connection with Figures 2A and 2B. Figure 11B shows the resulting package with a higher microcavity than in the previously described embodiments, making it suitable for devices that require more space, such as MEMS devices. The spacer 22 may be made by plating or electroplating of a metal, for example, gold. Alternatively the spacer may be made by deposition of a suitable material and subsequent patterning of the material.

Figure 11C shows the package after sawing and/or etching has been performed to uncover the electrically conductive wires 12 outside of the microcavity 7.

Figure 12 shows a cross-section of the microcavity and surroundings, taken between the first and the second wafer, according to one embodiment, seen from above. As can be seen, on the second wafer 2 the hermetic microcavity 7 is formed by a diffusion barrier 4, and a bonding ring 6 outside the diffusion barrier 4. Wires 8 for electrical connections extend from the inside of the hermetic microcavity 7 to the outside of the bonding ring 6. The wires are separated from the adhesive material and from the diffusion barrier by means of an isolation layer 10. In this embodiment the hermetic microcavity is square, but of course it can have any suitable shape.

Figure 13 shows a cross-section of the microcavity and surroundings taken between the first and the second wafer 1, 2, according to an alternative embodiment, seen from above. In this case, the adhesive material forms an open shape 6', whereas the diffusion barrier 4 is a closed shape inside the adhesive material. In Figure 13, the hermetic microcavity 7 is shown as a hexagon. Of course, in this embodiment as well, wires for electrical connections may be provided in the same way as discussed above.

Figures 14 and 15 show alternative embodiments in which the diffusion barrier diffusion barrier is formed by several interacting parts.

In Figure 14 a first and a second diffusion barrier ring 4f, 4g are provided on the first wafer 1 at a distance from each other and a third 4h, a fourth 4j and a fifth 4k diffusion barrier ring are provided on the second wafer. The width of the fourth diffusion barrier ring 4j corresponds to the distance between the first 4f and the second 4g diffusion barrier ring and the distance between the third 4h and fourth 4j diffusion barrier ring, and the fourth 4j and fifth 4k diffusion barrier ring, respectively, corresponds to the width of the first 4f and the second 4g diffusion barrier ring, respectively. In this way, when properly aligned, the diffusion barrier rings 4f, 4g, 4h, 4j, 4k will fit into each other to produce one wide diffusion barrier. The distance between the diffusion barrier rings 4h, 4j, 4k on the second wafer does not have to match the width of the diffusion barrier rings 4f, 4g on the first wafer exactly. If the distance is wider, several diffusion barriers separated from each other will be formed.

In Figure 15 the same configuration of diffusion barrier rings as in Figure 14 is used, except that the first and second diffusion barrier rings 4f, 4g' in this case are wider than the distance between the third 4h and fourth 4j diffusion barrier ring, and the fourth 4j and fifth 4k diffusion barrier ring, respectively. This promotes metal deformation and assures fusing of the metal rings by cold welding or thermocompression bonding, and sealing between the ring structures.

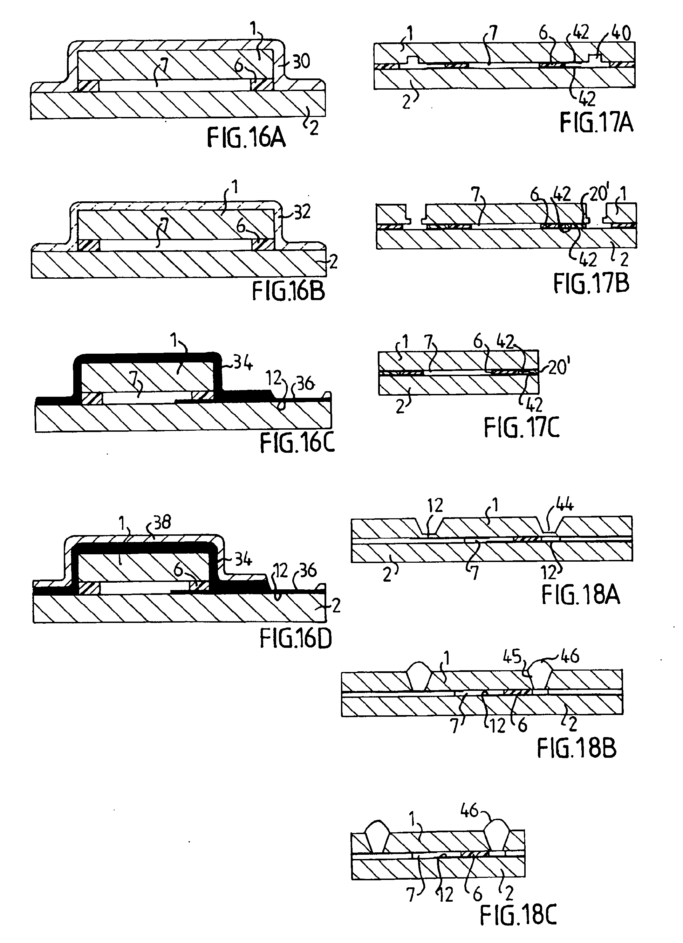

Figures 16A and 16B show alternative results of further processing of the package shown in Figure 10C (a first alternative result, in which the hermetic sealing was provided by electroplating, was shown in Figure 10D; Figures 10C and 10D not falling under the invention).

In Figure 16A a diffusion barrier layer 30 of metal sealant has been applied by means of sputtering, evaporation or chemical vapour deposition of a metal. The diffusion barrier material covers the whole of the first wafer 1 and the outermost part of the adhesive material 6 and at least a part of the surface of the second wafer 2.

In Figure 16B a diffusion barrier layer 32 has been applied by deposition of a non-metallic sealing material, for example a ceramic.

Figures 16C and 16D also show variants of the process of Figures 10A-10C (not falling under the invention), assuming an electrically conductive wire 12 was provided between the inside of the microcavity and the outside. In Figure 16C a non-metallic diffusion barrier layer 34, of an electrically insulating material, such as silicon nitride is used. This diffusion barrier layer 34 can therefore serve as a passivation layer for the electrically conductive wire 12. As can be seen in Figure 16C, no separate insulating layer has to be applied in the bonding process in this case. A contact pad 36 to the electrically conductive wire 12 has been created by patterning the passivation layer, that is, the diffusion barrier layer 34.

Figure 16D shows the package of Figure 16D, with an additional diffusion barrier layer 38 of metal sealant applied outside of the non-metallic diffusion barrier layer 34.

Figures 17A-17C show sealing of the microcavity on the outside of the bonding, using chip side metal plating. In this embodiment, as shown in Figure 17A, an outer microcavity 40 surrounds the bonding ring 6 delimiting the microcavity 7. Ouside the bonding ring 6 a plating seed metal layer 42 is placed on at least one of the two wafers. The plating seed metal layer or layers 42 extend along the surface of the wafer towards the outer microcavity 40. In Figure 17B the first wafer 1 has been patterned to open a connection to the outer microcavity 40 from the outside of the first wafer 1. A metal sealant has then been applied by side plating, said sealant forming a sealing ring 20' between the metal layers 42. In Figure 17C the wafer has been completely diced to separate the different packages. This latter step, of course, is optional.

Figure 17A-17B show only one of the possible ways of achieving the opening to the space where the sealing ring is to be formed. The skilled person will know how to make the opening also in the case where no outer microcavity is present.

Figures 18A-18C illustrate a method for forming vertical electrical contacts from the microcavity. In the bonding procedure, electrical conductors 12 were provided extending along said first and second wafer 1, 2 from the inside of the microcavity 7 to the outside of the package, as explained in connection with Figure 2. Then holes 44 extending almost through the first wafer down to the electrical conductors, have been formed by patterning and etching or powder blasting, to produce the component shown in Figure 18A. Blank, that is, unmasked etching has then been performed, followed by electroplating or plating of vias 45 filling the holes, and solder bumps 46 have been applied on top of the holes. The result of this is shown in Figure 18B in which the solder bumps 46 form contacts from the surface of the first wafer to the electrical conductors 12. Figure 18C shows the result after the optional step of dicing to separate the packages. This is known as flip-chip bonding. The via can contain one or more electrically conductive plating metals, which may or may not be the same as the solder bump 46.

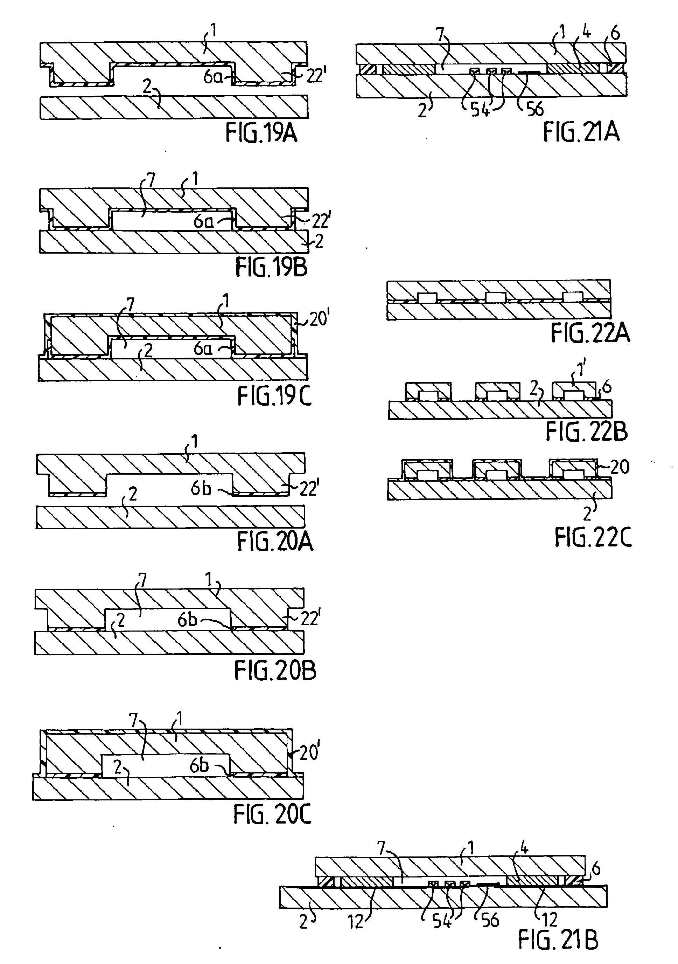

Figures 19A-19C illustrate a way of forming the bond, which is not covered by the invention and uses a spray-coated or electro-deposited adhesive to achieve localized bonding. In this example, a spacer 22' is formed on one of the wafers, in this case, the first wafer 1, which can also comprise patterned microcavities, notch structures, components and/or getters. Then a spray-coated adhesive layer 6a is applied to the whole surface of the first wafer 1. The adhesive will then bond the first and second wafer 1, 2 together only in the parts where the spacer 22' touches the second wafer 2. This is shown in Figure 19B. The remaining surface of the second wafer 2 will not be affected by the adhesive. After bonding of the wafers 1, 2 and patterning of the first wafer 1 a diffusion barrier 20' is applied on the outside of the package, as discussed above, to produce the result shown in Figure 19C. Any of the adhesives discussed above can be used for the adhesive layer 6a.

Figures 20A-20C show an alternative way of achieving localized adhesive bonding which also does not fall under the claimed invention. In Figure 20A, as in Figure 19A, the first wafer 1, comprises a spacer 22'. The spacer 22' has been pressed against a thin layer of adhesive that forms an adhesive layer 6" only on the surface of the spacer 22' that is to touch the second wafer 2. The resulting package is shown in Figure 20B. The adhesive forms a bonding ring 6b, which substantially only covers the interface between the spacer 22' and the second wafer 2. There is no, or very little, adhesive outside of the bonding ring 6b between the spacer and the second wafer 2. After bonding of the wafers 1, 2 and patterning of the first wafer 1, a diffusion barrier 20' is applied on the outside of the package, as discussed above, to produce the result shown in Figure 20C.

The way of bonding discussed in Figures 19A-19C and 20A-20C which do not fall under the invention can be used for bonding components also when no additional diffusion barrier is used, for example, where no particular atmosphere, or vacuum, is required inside the microcavity.

Figure 21A shows a complete package formed according to the first basic embodiment. A microcavity 7 is formed between the first and the second wafer 1, 2, by a bonding ring 6 and a diffusion barrier 4. In the microcavity 7 three components 54 are placed on the second wafer. In addition a getter 56 is placed on the second wafer.

Figure 21B shows another complete package formed according to the first basic embodiment. Here, electrical feed-through lines 12 have been applied from the inside of the microcavity 7 to the outside of the package, to provide electrical contact to three components 54, and to a getter 56, respectively, all of which are placed on the second wafer 2 in the microcavity 7.

The opening may be used for several different purposes, for example, for contact areas for the electrically conductive wires.

In Figures 21A and 21B the components may be any of the components discussed above, for example, integrated circuits, sensors or integrated sensor or actuator systems.

Figure 22A shows a larger section of the wafers 1, 2, comprising several sealed packages not falling under the invention. For each package the first wafer 1 and the second wafer 2 are bonded together by a bonding layer 6.

In Figure 22B, also not falling under the invention, the first wafer has then been patterned to form the capping wafer 1' of tree separate packages on the second wafer 2.

In Figure 22C also not falling under the invention a diffusion barrier layer 20 has been applied on the outside of each package. Instead of, or in addition to the outer diffusion barrier layer 20, one or more diffusion barriers may be found inside the bonding layer relative to the microcavity, as shown i.a. in Figure 1A.

As will be obvious to the skilled person the embodiments shown in the Figures and described above can be varied and combined. For example, conductors can be provided in the way discussed in connection with Figures 2A and 2B, and 9A and 9B, also with the embodiments of the diffusion barrier shown in Figures 5A, 6A, 7A 8A or 10D. The profiles of the diffusion barrier can be varied while still achieving plastic deformation of the rings. Getters can be used inside the microcavities in all embodiments. Getter materials are commonly used to support vacuum atmospheres inside microcavities. The getter materials have the ability to react with certain gas molecules and absorb or bind them and thus improve the vacuum in a microcavity. Getter materials can be applied in chip-scale or wafer-scale encapsulations. The getter material may be locally deposited on the first and/or second wafer prior to the wafer bonding. The getter may also be formed by depositing and patterning a suitable getter material.

## Claims

1. A method of hermetically sealing at least one microcavity (7) between a first wafer (1) and a second wafer (2), said method comprising the steps of providing on at least one of the first and second wafers (1, 2) a closed shape of a sealing material suitable for forming at least one diffusion barrier (4), and providing an intermediate bonding material (6) spaced from the sealing material on at least one of the first and second wafers (1, 2), the intermediate bonding material comprising an adhesive, aligning said first and second wafers (1, 2) and applying pressure to form the at least one diffusion barrier (4) and to create a bond to join the first wafer (1) and the second wafer (2) together.

2. A method according to claim 1 wherein the diffusion barrier (4) is formed by a metal.

3. A method according to claim 1 or claim 2 comprising the step of providing a sealing material on both the first and second wafers (1, 2) such that the sealing material on both wafers (1, 2) interacts to form one diffusion barrier (4).

4. A method according to any one of the preceding claims wherein the sealing material is shaped in such a way that it is plastically deformed by pressure and fused together by cold welding.

5. A method according to any one of the preceding claims wherein the first and second wafers (1, 2) are joined and the intermediate bonding material (6) is then cured to form the bond between the wafers (1, 2).

6. A method according to any one of the preceding claims wherein the diffusion barrier (4) is a closed shape and the structure formed from intermediate bonding material (6) is not a closed shape.

7. A method according to any one of the preceding claims wherein:
i) the first wafer (1) comprises one diffusion barrier ring (4a) and the second wafer (2) comprises two or three diffusion barrier rings (4b, 4c), such that the diffusion barrier is formed by three interacting parts;
ii) the first wafer (1) comprises two diffusion barrier rings (4f, 4g, 4f, 4g') and the second wafer (2) comprises three diffusion barrier rings (4h, 4j, 4k, 4h', 4j', 4k') such that the diffusion barrier (4) is formed by five interacting parts; or
iii) the first and second wafers (1, 2) comprise matching rings of diffusion barrier material (4) and matching rings of bonding material (6);
and wherein the diffusion barrier rings on the first wafer interact with the diffusion barrier rings on the second wafer to plastically deform the sealing material to perform cold welding of the sealing material.

8. A method according to claim 7, wherein the step of forming the at least one diffusion barrier (4) by the applied pressure also creates a bonding effect between the first and second wafers (1, 2).

9. A method according to any one of the preceding claims, wherein at least two different sealing materials are used to form said at least one diffusion barrier.

10. A method according to any one of the preceding claims, further comprising the step of providing at least one electrical contact (12) from the inside of the microcavity to the outside of the package.

11. A method according to any one of the preceding claims, wherein the intermediate bonding material comprises an epoxy.

12. A method according to any one of the preceding claims, wherein the bond is formed by applying the intermediate bonding material to the first and second wafers by a coating process.

13. A hermetically sealed package comprising a microcavity (7) defined by a first wafer (1) and a second wafer (2) joined together by a bonding structure (6) formed by an intermediate bonding material, wherein the bonding material comprises an adhesive, and further comprising at least one diffusion barrier (4) which is spaced from the bonding structure, **characterized in that** the at least one diffusion barrier (4) is a closed shape formed from respective sealing material structures each disposed on a respective said first and second wafer.

14. A hermetically sealed package according to claim 13, wherein the at least one diffusion barrier (4) is formed inside the microcavity.

## Patentansprüche

1. Verfahren zum hermetischen Verschließen wenigstens einer Mikrokavität (7) zwischen einem ersten Wafer (1) und einem zweiten Wafer (2), wobei das Verfahren die Schritte umfasst: Bereitstellen einer geschlossenen Form aus einem Verschlussmaterial auf wenigstens einem aus dem ersten und zweiten Wafer (1, 2), das zum Bilden wenigstens einer Diffusionsbarriere (4) geeignet ist, und Bereitstellen eines dazwischenliegenden Verbindungsmaterials (6) mit einem Abstand vom Verschlussmaterial an wenigstens einem der ersten und zweiten Wafer (1, 2), wobei das Verbindungsmaterial ein Klebemittel umfasst, Ausrichten des ersten und zweiten Wafers (1, 2) und Anwenden von Druck, um die wenigstens eine Diffusionsbarriere (4) zu bilden und eine Verbindung zu erzeugen, um den ersten Wafer (1) und den zweiten Wafer (2) miteinander zu verbinden.

2. Verfahren nach Anspruch 1, bei dem die Diffusionsbarriere (4) durch ein Metall gebildet wird.

3. Verfahren nach Anspruch 1 oder 2, umfassend den Schritt Bereitstellen eines Verschlussmaterials auf sowohl dem ersten als auch dem zweiten Wafer (1, 2), so dass das Verschlussmaterial auf beiden Wafern (1, 2) zusammenwirkt, um eine Diffusionsbarriere (4) zu bilden.

4. Verfahren nach einem der vorhergehenden Ansprüche, wobei das Verschlussmaterial in solcher Weise geformt ist, dass es durch Druck plastisch verformt und durch Kaltschweißen miteinander verschmolzen wird.

5. Verfahren nach einem der vorhergehenden Ansprüche, bei dem der erste und zweite Wafer (1, 2) zusammengefügt werden und das dazwischenliegende Verbindungsmaterial (6) dann gehärtet wird, um die Verbindung zwischen den Wafern (1, 2) zu bilden.

6. Verfahren nach einem der vorhergehenden Ansprüche, bei dem die Diffusionsbarriere (4) eine geschlossene Form ist und die aus dem dazwischenüegenden Verbindungsmaterial (6) gebildete Struktur keine geschlossene Form ist.

7. Verfahren nach einem der vorhergehenden Ansprüche, wobei:
i) der erste Wafer (1) einen Diffusionsbarrierenring (4a) umfasst und der zweite Wafer (2) zwei oder drei Diffusionsbamerenringe (4b, 4c) umfasst, so dass die Diffusionsbarriere von drei zusammenwirkenden Teilen gebildet wird;
ii) der erste Wafer zwei DifFusionsbarrierenringe (4f, 4g, 4f, 4g') umfasst und die zweite Wafer (2) drei Diffusionsbarrierenringe (4h, 4j, 4k, 4h', 4j', 4k') umfasst, so dass die Diffusionsbarriere von fünf zusammenwirkenden Teilen gebildet wird; oder
iii) der erste und zweite Wafer (1, 2) zusammenpassende Ringe aus Diffusionsbarrierenmaterial (4) und zusammenpassende Ringe aus Verbindungsmaterial (6) umfassen;
und wobei die Diffusionsbamerenringe auf dem ersten Wafer mit den Diffusionsbarrierenringen auf dem zweiten Wafer zusammenwirken, um das Verschlussmaterial plastisch zu verformen, um ein Kaltschweißen des Verschlussmaterials auszuführen.

8. Verfahren nach Anspruch 7, bei dem der Schritt des Ausbildens wenigstens einer Diffusionsbarriere (4) durch angewendete Druck auch eine Verbindungswirkung zwischen dem ersten und zweiten Wafer (1, 2) erzeugt.

9. Verfahren nach einem der vorhergehenden Ansprüche, bei dem wenigstens zwei verschiedene Verschlussmaterialien verwendet werden, um die wenigstens eine Diffusionsbarriere auszubilden.

10. Verfahren nach einem der vorhergehenden Ansprüche, weiterhin umfassend den Schritt Bereitstellen wenigstens eines elektrischen Kontakts (12) vom Inneren der Mikrokavität zum Äußeren des Pakets.

11. Verfahren nach einem der vorhergehenden Ansprüche, bei dem das dazwischenliegende Verbindungsmaterial ein Epoxid umfasst.

12. Verfahren nach einem der vorhergehenden Ansprüche, bei dem die Verbindung ausgebildet wird durch Aufbringen des dazwischenliegenden Verbindungsmaterials auf dem ersten und zweiten Wafer durch einen Beschichtungsvorgang.

13. Hermetisch verschlossenes Paket umfassende eine Mikrokavität (7), definiert durch einen ersten Wafer (1) und einen zweiten Wafer (2), zusammengefügt durch eine Verbindungsstruktur (6), ausgebildet durch ein dazwischenliegendes Verbindungsmaterial, wobei das Verbindungsmatcriat ein Klebemittel umfasst, und ferner umfassend wenigstens eine Diffusionsbarriere (4), die mit Abstand von der Verbindungsstruktur angeordnet ist, **dadurch gekennzeichnet, dass** die wenigstens eine Diffusionsbarriere (4) eine geschlossene Form ist, die aus jeweiligen Verschlussmaterialstrukturen gebildet ist, die jeweils auf einem jeweiligen ersten und zweiten Wafer angeordnet sind.

14. Hermetisch verschlossenes Paket nach Anspruch 13, bei dem die wenigstens eine Diffusionsbarriere (4) in der Mikrokavität ausgebildet ist.

## Revendications

1. Procédé pour fermer hermétiquement au moins une microcavité (7) entre une première plaquette (1) et une seconde plaquette (2), ledit procédé comprenant les étapes consistant à prévoir sur au moins l'une des première et seconde plaquettes (1, 2), une forme fermée d'un matériau d'étanchéité approprié pour former au moins une barrière de diffusion (4) et prévoir un matériau de liaison intermédiaire (6) espacé du matériau d'étanchéité sur au moins l'une des première et seconde plaquettes (1, 2), le matériau de liaison intermédiaire comprenant un adhésif, aligner lesdites première et seconde plaquettes (1, 2) et appliquer une pression pour former la au moins une barrière de diffusion (4) et pour créer une liaison afin d'assembler la première plaquette (1) et la seconde plaquette (2) ensemble.

2. Procédé selon la revendication 1, dans lequel la barrière de diffusion (4) est formée par un métal.

3. Procédé selon la revendication 1 ou la revendication 2, comprenant l'étape consistant à prévoir un matériau d'étanchéité à la fois sur la première et la seconde plaquette (1, 2) de sorte que le matériau d'étanchéité sur les deux plaquettes (1, 2) interagit pour former une barrière de diffusion (4).

4. Procédé selon l'une quelconque des revendications précédentes, dans lequel le matériau d'étanchéité est formé de sorte qu'il est plastiquement déformé par la pression et fondu par un soudage à froid.

5. Procédé selon l'une quelconque des revendications précédentes, dans lequel les première et seconde plaquettes (1, 2) sont assemblées et le matériau de liaison intermédiaire (6) est ensuite durci pour former la liaison entre les plaquettes (1, 2).

6. Procédé selon l'une quelconque des revendications précédentes, dans lequel la barrière de diffusion (4) est une forme fermée et la structure formée à partir du matériau de liaison intermédiaire (6) n'est pas une forme fermée.

7. Procédé selon l'une quelconque des revendications précédentes, dans lequel :
i) la première plaquette (1) comprend une bague de barrière de diffusion (4a) et la seconde plaquette (2) comprend deux ou trois bagues de barrière de diffusion (4b, 4c) de sorte que la barrière de diffusion est formée par trois parties d'interaction ;
ii) la première plaquette (1) comprend deux bagues de barrière de diffusion (4f, 4g, 4f', 4g') et la seconde plaquette (2) comprend trois bagues de barrière de diffusion (4h, 4j, 4k, 4h', 4j', 4k') de sorte que la barrière de diffusion (4) est formée par cinq parties d'interaction ; ou bien
iii) les première et seconde plaquettes (1, 2) comprennent des bagues correspondantes de matériau de barrière de diffusion (4) et des bagues correspondantes de matériau de liaison (6) ;
et dans lequel les bagues de barrière de diffusion sur la première plaquette interagissent avec les bagues de barrière de diffusion sur la seconde plaquette pour déformer plastiquement le matériau d'étanchéité afin de réaliser le soudage à froid du matériau d'étanchéité.

8. Procédé selon la revendication 7, dans lequel l'étape consistant à former la au moins une barrière de diffusion (4) par la pression appliquée crée également un effet de liaison entre les première et seconde plaquettes (1, 2).

9. Procédé selon l'une quelconque des revendications précédentes, dans lequel au moins deux matériaux d'étanchéité différents sont utilisés pour former ladite au moins une barrière de diffusion.

10. Procédé selon l'une quelconque des revendications précédentes, comprenant en outre l'étape consistant à prévoir au moins un contact électrique (12) à partir de l'intérieur de la microcavité vers l'extérieur de l'emballage.

11. Procédé selon l'une quelconque des revendications précédentes, dans lequel le matériau de liaison intermédiaire comprend une résine époxy.

12. Procédé selon l'une quelconque des revendications précédentes, dans lequel la liaison est formée en appliquant le matériau de liaison intermédiaire sur les première et seconde plaquettes par un procédé de revêtement.

13. Emballage hermétiquement fermé comprenant une microcavité (7) définie par une première plaquette (1) et une seconde plaquette (2) assemblées par une structure de liaison (6) formée par un matériau de liaison intermédiaire, dans lequel le matériau de liaison comprend un adhésif, et comprenant en outre au moins une barrière de diffusion (4) qui est espacée de la structure de liaison, **caractérisé en ce que** la au moins une barrière de diffusion (4) est une forme fermée, formée à partir de structures de matériau d'étanchéité respectives, chacune disposée sur une plaquette respective desdites première et seconde plaquettes.

14. Emballage hermétiquement fermé selon la revendication 13, dans lequel la au moins une barrière de diffusion (4) est formée à l'intérieur de la microcavité.
